# EUROPEAN PATENT APPLICATION

(11) **EP 2 246 912 A1**
(43) Date of publication of application: **03.11.2010**
(21) Application number: 10160767.9
(22) Date of filing: 22.04.2010
(51) Int. Cl.: H01L 33/40

(54) **Light emitting device and light emitting device package**

(30) Priority: 28.04.2009 KR 20090036984
(71) Applicant: LG Innotek Co., Ltd., Seoul 100-714 (KR)
(72) Inventor: Kim, Sun Kyung, Gyeonggi-do (KR)
(74) Representative: Vignesoult, Serge L. M.

(57) **Abstract**

A light emitting device (LED) (100) includes a light emitting structure and a reflective layer (150). The light emitting structure includes a semiconductor layer (110) of a first conductivity type, a light emitting layer (120), and a semiconductor layer (130) of a second conductivity type, and the reflective layer (150) is provided adjacent to the semiconductor layer of the second conductivity-type. The light emitting layer includes multiple quantum wells, and a distance between adjacent quantum wells is about 2n ± Δ, where λ represents a wavelength of emitted light, n represents an average refractive index of a medium disposed between the reflective layer and the light emitting layer, and Δ ≤ λ/8n.

## Description

### BACKGROUND

### 1. Field

One or more embodiments described herein relate to the emission of light.

### 2. Background

Light emitting devices (LEDs) are used for a variety of purposes including image generation. One factor that affects the generation of light from these devices is internal quantum efficiency. One approach for improving internal quantum efficiency involves growing high quality thin films in a stacked structure. Another approach seeks to increase light extraction efficiency through geometric shape control. However, these and other approaches have proven inadequate.

### BRIEF DESCRIPTION OF THE DRAWINGS

Fig. 1 is a diagram showing one embodiment of a light emitting device.

Fig. 2 is a diagram showing a light emitting layer in the LED of Fig. 1.

Fig. 3 is a light extraction efficiency graph for the LED of Figs. 1 and 2.

Fig. 4 is a diagram showing an embodiment of an LED package.

### DETAILED DESCRIPTION

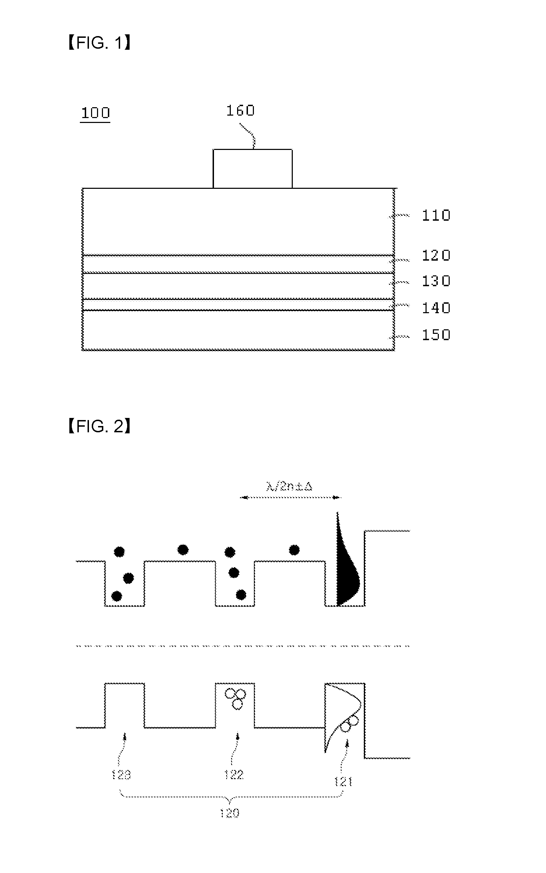

Fig. 1 shows a cross-sectional view of one embodiment of a light emitting device (LED), and Fig. 2 shows an enlarged view of a light emitting layer of this device. The LED includes a reflective layer 150, a second electrode layer 140 on the reflective layer, a semiconductor layer 130 of a second conductivity-type on the second electrode layer, a light-emitting layer 120 that includes multiple coherent quantum wells over the semiconductor layer 130, and a semiconductor layer 110 of a first conductivity-type over the light-emitting layer. A first electrode 160 is provided over the semiconductor layer 110.

In accordance with one embodiment, the distance(s) between the multiple coherent quantum wells may be adjusted or set to obtain a predetermined or improved light-extraction efficiency. This may achieved through a light-emission pattern adjustment effect within light emitting layer 120 to be described in greater detail below.

When a reflective layer having high reflectance is disposed around or adjacent to the light-emitting layer, a characteristic of the light-emitting layer may be adjusted or set based on a distance between the light-emitting layer and the reflective layer. For example, when an electric dipole is disposed within a single dielectric space in which a reflective layer is not included, a maximum point of an emission pattern is distributed perpendicular to a vibration direction.

However, when a reflective layer having high reflectance is disposed around or adjacent the electric dipole, light emitting characteristics are different, e.g., light may be concentrated in a vertical direction depending on, for example, a distance between the electric dipole and reflective layer, or light may proceed along a surface of the reflective layer. If the distance between the reflective layer and light-emitting layer is set, so that light from each quantum well mainly has a vertical direction component, light-extraction efficiency of the LED may be improved.

The pattern of the light-emitting layer may be adjusted through the reflective layer based on an interference effect that occurs between light from the light-emitting layer and light from the reflective layer. When no reflective layer is provided around the light-emitting layer, or when the distance between the reflective layer and light emitting layer is sufficiently large so that interference effects can be ignored, then light from the light-emitting layer may approach a spherical wave having the same or substantially the same coefficient in all directions.

However, when a reflective layer is provided, the light-emitting layer may be adjusted to generate a desired emission pattern and constructive interference may be generated to cause light to be concentrated in the vertical or another desired direction. When this is applied to a vertical-type LED, the distance between the quantum well of the light-emitting layer 120 and reflective layer 150 may be adjusted or set based on, for example, a thickness of the second conductivity-type semiconductor layer 130.

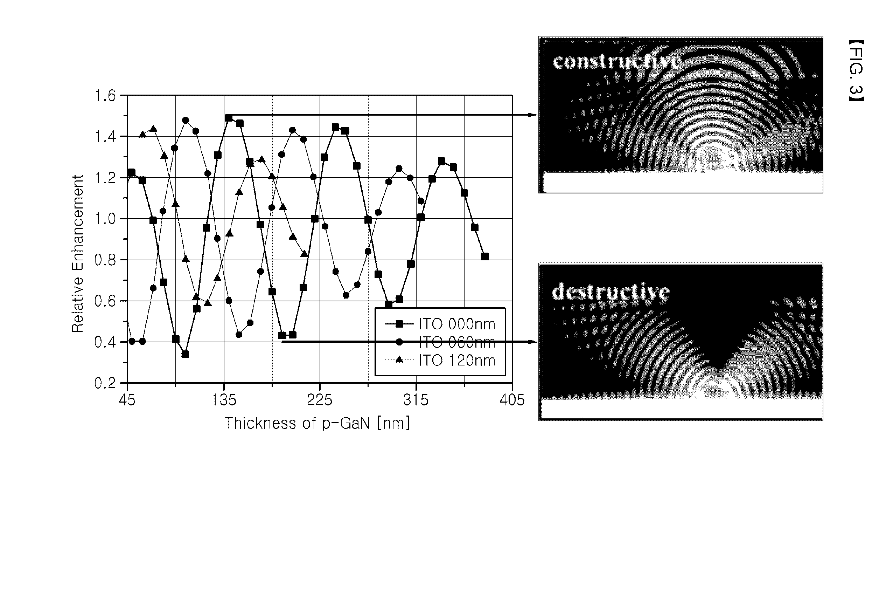

Fig 3 shows an example of light extraction efficiency that may be obtained for variations in light-emission patterns based on the distance between the reflective and light emitting layers. The distance between the reflective layer (e.g., indium tin oxide (ITO)) of the second electrode layer and the light emitting layer is adjusted through 3-D finite difference time domain (FDTD) simulation to arithmetically calculate an increment of the light-extraction efficiency according to a variation of the light-emission pattern.

The light emitting layer may include an electric dipole in which polarizations in x, y, and z directions are randomly mixed with each other. When looking at the increment result of the light extraction efficiency, it is seen that a maximum point (constructive interference) and a minimum point (destructive interference) of the light-extraction efficiency alternately occur in a cycle of about λ/4n. This is evidence indicating that a radiation pattern is adjusted by the interference of light.

Actually, when the radiation pattern is observed at the maximum point and minimum point of light extraction efficiency, the light is strongly emitted in a vertical direction at the maximum point. Conversely, a relatively small amount of light exists in the vertical direction at the minimum point. In this case, almost all the light is emitted at an inclined angle that is greater than a critical angle at which the light is totally reflected.

The adjustment of the light-emission pattern by the reflective layer indicates estimated results based on a thin quantum well. If the number of quantum wells increases such that, the light emitting layer is made to have a thickness greater than about λ/2n, the light-emission pattern adjustment effect may be reduced or even eliminated, e.g., a constructive interference condition and a destructive interference condition are mixed with each other, thereby resulting in an averaged light emission pattern. Because of the light-emission pattern adjustment effect, the number of quantum wells should be reduced and the thickness of the light-emitting layer should be less than about λ/2n.

However, when the number of quantum wells is reduced, the confinement probability of holes and electrons may be reduced to degrade the internal quantum wells. Thus, although the light-emission pattern adjustment effect exists, final efficiency when considering the internal quantum well and light-extraction efficiency may be ineffective or reduced in the increment.

In accordance with one embodiment, in order to obtain improved or desired light-extraction efficiency through the light-emission pattern adjustment effect using thick multiple quantum wells, a distance between the quantum wells may be set to about λ/2n ± Δ. (where, λ represents a wavelength of the emitted light, n represents an average refractive index of a medium disposed between the second electrode layer and the light emitting layer, and Δ ≤ λ/8n). The distance between the wells may be, for example, the distance between centers of two adjacent wells, between leading edges of the two adjacent wells, or between trailing edges of the two adjacent wells, which are applicable to all embodiments described herein.

As shown in Fig. 2, the quantum wells may be included in a layer in which light is generated by recombination of electrons and holes, e.g., light may be emitted from the quantum wells within the light-emitting layer.

When light from the light emitting layer constructively interferes with light from the reflective layer, light emission efficiency may be considered to be maximized. Because the reflective layer is located at a position in which constructive interference is generated with respect to the vertical direction, light in the vertical direction may be generated. Thus, originally upwardly emitted light and upwardly emitted light originally downwardly emitted and then reflected by a mirror have the same constructive interference in phase, light in and/or around the vertical direction may be at an increased brightness or original brightness.

For example, the distance between reflective layer 150 and a quantum well most adjacent to the reflective layer may be represented as (2m+1)(λ/4n) - 2α±Δ), where m represents a constant greater than zero, λ represents a wavelength of the emitted light, n represents an average refractive index of a medium disposed between the second electrode layer and light-emitting layer, α represents a skin depth of light within the reflective layer, and Δ ≤ λ/8n.

When light is incident on the reflective layer, a portion of the light may permeate into the surface of the reflective layer. This is referred to as the skin depth. Thus, a movement distance of the light may increase. For example, the emitted light may permeate into the reflective layer by a distance α. Then, light reflected by the reflective layer permeates again into the reflective layer by the distance α. As a result, the movement distance of the light may increase by the total permeated distance (2α). Thus, the distance between the surface of reflective layer 150 and the quantum well most adjacent to the reflective layer of the multiple quantum wells may be set by considering the total permeated distance (2α).

As a result, although multiple quantum wells are provided, for example, when the quantum wells are respectively disposed at 3λ/4n, 5λ/4n, and 7λ/4n from the reflective layer, light emission efficiency may be maximized in a desired (e.g., vertical) direction. Here, the distance between the quantum wells may be λ/2n ± Δ.

In this embodiment, light generated by a hole-electron recombination process occurring within each of the quantum wells is vertically polarized. This represents that the multiple quantum wells have the same tendency as the single quantum well. That is, the vertically polarized light-emission pattern adjustment effect may be obtained without sacrificing initial internal quantum efficiency. Because all wells of the multiple quantum well structure may participate in a quantum effect with the same phase, the multiple quantum wells in this embodiment may be referred to as "coherent multiple quantum wells." Other embodiments, however, may not have this same phase and thus may use different types of quantum wells.

Fig. 2 shows a cross-sectional view of one embodiment of light emitting layer 120 of an LED. As shown, the light emitting layer may include a plurality of quantum wells including a first quantum well 121, a second quantum well 122, and a third quantum well 123. The number of quantum wells may be varied, for example, according to design specifications or an intended application.

A distance between reflective layer 150 of the second electrode layer and first quantum well 121 most adjacent to the reflective layer may be expressed as (2m+1)(λ/4n) ± Δ. The distance between the quantum wells may the same or different. When the distance between the wells is the same, the distance may be expressed as λ/2n ± Δ.

Referring again to Fig. 2, although the plurality of quantum wells exists with the multiple coherent quantum well, each of the quantum wells may not have the same density or concentration of electrons and holes. For example, because hole mobility tends to be large, a region including first quantum well 121 (that is adjacent to the second conductive-type semiconductor layer from which the holes are supplied) is first filled with holes. Accordingly, the probability of recombination of holes and electrons may be greatest at the first quantum well 121 in this embodiment.

One embodiment of a method for manufacturing an LED as shown in Figs. 1 and 2 will now be described. An initial step of the method includes forming a light emitting structure on a first substrate, which is subsequently removed. Alternatively, the light-emitting structure may be formed on a conductive substrate such as the second electrode layer.

The light-emitting structure including first conductive-type semiconductor layer 110 of a first conductivity type, active layer 120, and semiconductor layer 130 of a second conductivity type is formed on the first substrate. An undoped semiconductor layer may be formed between the first substrate and semiconductor layer 110.

The light-emitting structure may be an AlGaInN semiconductor layer. However, a different semiconductor material may be used. The first substrate may be, for example, a sapphire single crystal substrate, and a wet etching process may be performed to remove impurities on a surface of the first substrate.

Thereafter, the semiconductor layer 110 is formed on the first substrate using, for example, a chemical vapor deposition (CVD) process, a molecular beam epitaxy (MBE) process, a sputtering process, or a hydride vapor phase epitaxial (HVPE) deposition process. Also, trimethylgallium gas (TMGa), ammonia gas (NH₃), nitrogen gas (N₂), and silane gas (SiH₄) containing silicon (Si) and n-type impurities may be injected into a chamber to form the first conductive-type semiconductor layer 110.

Thereafter, active layer 120 is formed on the semiconductor layer 110. The active layer may include at least one of a multiple quantum well (MQW) structure, a quantum wire structure, or a quantum dot structure. According to one embodiment, the active layer may have a multiple quantum well structure formed by injecting trimethyl gallium gas (TMGa), ammonium gas (NH₃), nitrogen gas (N₂), and Trimethyl indium gas (TMIn). Different gases may be injected in other embodiments.

Furthermore, the active layer may have one or more of an InGaN/GaN structure, an InGaN/InGaN structure, an AlGaN/GaN structure, an InAlGaN/GaN structure, a GaAs/AlGaAs(InGaAs) structure, or a GaP/AlGaP(InGaP) structure. As shown in Fig. 2, the active layer serving as a light-emitting layer 120 may include a plurality of quantum wells such as a first quantum well 121, a second quantum well 122, and a third quantum well 123.

As previously indicated, in order to obtain improved light-extraction efficiency through a light-emission pattern adjustment effect within a thick multiple quantum well, the distance between the quantum wells may be about λ/2n ± Δ, where λ represents the wavelength of emitted light, n represents an average refractive index of a medium disposed between the second electrode layer and the light emitting layer, and Δ ≤ λ/8n.

According to one embodiment, the distance between multiple coherent quantum wells may be adjusted using a barrier. An epitaxial field may be formed such that holes and electrons are easily moved into a widened barrier. That is, for multiple coherent quantum wells, the distance between the wells may be adjusted through or based on a thickness of the barrier. According to one embodiment, the wells and barrier may have thicknesses of less than several nanometers, respectively, but different thicknesses may be used in other embodiments.

Thereafter, second conductive type semiconductor layer 130 is formed on the active layer. For example, bis(ethylcyclopentadienyl) magnesium (EtCp2Mg) {Mg(C2H5C5H4)2} containing p-type impurities such as trimethyl gallium (TMGa) gas, ammonia (NH3) gas, nitrogen (N2) gas, and magnesium (Mg) may be injected into the chamber to form the second conductive type semiconductor layer. In other embodiments, a different technique and/or gases may be used.

The second electrode layer may be formed on the semiconductor layer 130, and may include ohmic layer 140 and reflective layer 150 and optionally one or more of an adhesion layer and a second substrate.

According to one example, the second electrode 150 may include ohmic layer 140. Here, a single metal or a metal alloy may be multiply stacked to improve the efficiency of electron-hole injection. The ohmic layer may be formed of at least one of ITO, IZO(In-ZnO), GZO(Ga-ZnO), AZO(Al-ZnO), AGZO(Al-Ga ZnO), IGZO(In-Ga ZnO), IrOx, RuOx, RuOx/ITO, Ni/IrOx/Au, Ni/IrOx/Au/ITO, Ni, Pt, Cr, Ti, and Ag, but is not limited thereto.

The second electrode layer may include the reflective layer or the adhesion layer. For example, when second electrode 150 includes the reflective layer, the second electrode may include a metal layer containing Al, Ag, or an alloy containing Al or Ag. The material such as Al or Ag may effectively reflect light generated at the active layer to improve light extraction efficiency of the LED.

When light from the light-emitting layer constructively interferes with light from the reflective layer, light-emission efficiency may be maximized. In one embodiment, because reflective layer 150 is disposed at a position in which the constructive interference is generated with respect to the vertical direction, light-emitting layer 120 may generate light in the vertical direction. That is, in the light emitted from the light emitting layer 120, when originally upwardly emitted light and upwardly emitted light that is originally downwardly emitted and then refracted by a mirror have the same constructive interference in phase, the light around the vertical direction may be originally strength.

For example, a distance between reflective layer 150 and the quantum well most adjacent to the reflective layer may be expressed as (2m+1)(λ/4n) *-* 2α ± Δ). Here, m is a constant greater than zero, λ represents the wavelength of emitted light, n represents an average refractive index of a medium disposed between the second electrode layer and light-emitting layer, α represents a skin depth of light within the reflective layer, and Δ ≤ λ/8n.

When light is reflected by the reflective layer, a portion of the light may permeate into a surface of the reflective layer. (This is referred to as the skin depth). Thus, a movement distance of the light may increase.

For example, emitted light may permeate into the reflective layer by a distance α, and then the light may be reflected by the reflective layer and permeate again into the reflective layer by the distance α. As a result, the movement distance of the light may increase by a total permeated distance (2α). Thus, the distance between the surface of reflective layer 150 and the quantum well most adjacent to the reflective layer may be designed by taking the total permeated distance (2α) into consideration.

As a result, although a multiple quantum well structure is provided (for example, when the quantum wells are respectively disposed at 3λ/4n, 5λ/4n, and 7λ/4n from the reflective layer), light-emission efficiency may be maximized. Here, the distance between the quantum wells may be expressed as λ/2n ± Δ.

For example, a distance between reflective layer 150 of the second electrode layer and first quantum well 121 most adjacent to the reflective layer of the multiple coherent quantum wells may be expressed as (2m+1)(λ/4n) ± Δ) in a constructive interference condition.

When second electrode layer 140 includes an adhesion layer (not shown), the reflective layer may serve as the adhesion layer, or the adhesion layer may be formed using Ni or Au. The second electrode 150 may include the second substrate (not shown).

When the first conductive-type semiconductor layer 110 has a sufficiently large thickness (e.g., about 50 µm), the second substrate formation process may be omitted. The second substrate may be formed of a metal having good conductive properties, a metal alloy, or a conductive semiconductor material to efficiently inject the electron holes. For example, the second substrate may be formed of one of more of copper (Cu), a Cu alloy, Si, molybdenum (Mo), and SiGe. The second substrate may be formed using an electrochemical metal deposition method or a bonding method using eutectic metals.

Thereafter, the first substrate is removed to expose the semiconductor layer 110. The first substrate may be separated using a high power laser or removed using a chemical etching process. Also, the first substrate may be removed by performing a physical grinding process. The first substrate is removed to expose the semiconductor layer 110 or a undoped semiconductor layer. Thereafter, the first electrode 160 may be formed on first conductive-type semiconductor layer 110.

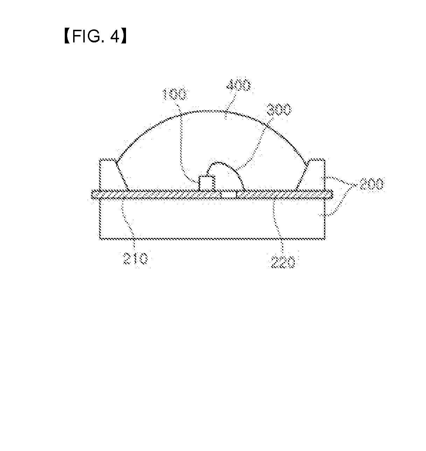

Fig. 4 shows one embodiment of a cross-sectional view of an LED package that includes a body 200, a third electrode layer 210 and a fourth electrode layer 220 disposed in the body 200, an LED 100 disposed in the body 200 and electrically connected to the third electrode layer 210 and the fourth electrode layer 220, and a molding member 400 surrounding the LED 100. The body 200 may be formed of a silicon material, a synthetic resin material, or a metal material, and a sloped surface may be disposed around the LED 100.

The third electrode layer 210 and fourth electrode layer 220 are electrically separated from each other and supply a power to the LED. The third and fourth electrode layers may reflect light generated by the LED to improve light efficiency. In addition, the third and fourth electrode layers may release heat generated in the LED to the outside. The LED may be a vertical-type LED or a lateral-type LED, and may be disposed on body 200 or on third electrode layer 210 or fourth electrode layer 220.

Furthermore, the LED may be electrically connected to the third electrode layer and/or the fourth electrode layer through a wire 300. In this embodiment, because a vertical-type LED has been shown in this example, one wire may is used but multiple wires and/or multiple connections to or from the LED may exist in other embodiments. For another example, two wires may be used for a lateral-type LED. Also, when the LED includes a flip-chip-type LED, no wires 300 may be used.

In addition to the foregoing features, a molding member 400 may provided to surround and protect the LED. Also, a phosphor may be contained in the molding member to vary a wavelength of light emitted from the LED. The LED package includes at least one LED or may include a plurality of LEDs.

According to one embodiment, a plurality of LED packages may be arrayed on a substrate, and a light guide panel, prism sheet, and diffusion sheet as optical members may be disposed along an optical path of the LED package. The LED package, a substrate, and the optical members may serve as a light unit. In other embodiments, a display device, indication device, and/or light system may be formed to include an LED or LED package in accordance with the embodiments described herein. For example, a lighting system in the form of a lamp or streetlight may include a light-emitting module including the LED package described herein.

One or more embodiments described herein provide a light emitting device that can obtain improved light-extraction efficiency through a light emission pattern adjustment effect and using a relatively thick light emitting layer that includes a multiple quantum well structure, and a light emitting device package including the same.

In one embodiment, a light emitting device (LED) comprises a light emitting structure comprising a first conductivity-type semiconductor layer, a light emitting layer, and a second conductivity-type semiconductor layer, wherein the light emitting layer comprises a multiple quantum well, and a distance between quantum wells within the multiple quantum well is about λ/2n ± Δ (where, λ represents a wavelength of emitted light, n represents an average refractive index of a medium disposed between a second electrode layer and the light emitting layer, and Δ ≤ λ/8n).

In another embodiment, a light emitting device (LED) comprises a light emitting structure comprising a first conductivity-type semiconductor layer, a light emitting layer comprising a multiple quantum well, and a second conductivity-type semiconductor layer; and a reflective layer on the light emitting structure, wherein a distance between the reflective layer and the quantum well most adjacent to the reflective layer corresponds to a constructive interference condition.

In another embodiment, a light emitting device (LED) package comprises a light emitting structure comprising a first conductivity-type semiconductor layer, a light emitting layer comprising a multiple quantum well, and a second conductivity-type semiconductor layer and a reflective layer on the light emitting structure; and a package body in which the LED is disposed, wherein a distance between the reflective layer and the quantum well most adjacent to the reflective layer corresponds to a constructive interference condition.

In accordance with another embodiment, a light emitting device (LED) comprises a light emitting structure comprising a first conductive type semiconductor layer, a light emitting layer, and a second conductive type semiconductor layer; and a reflective layer provided adjacent to the second conductive type semiconductor layer, wherein the light emitting layer includes multiple quantum wells, and a distance between adjacent quantum wells is about λ/2n+Δ (where, λ represents a wavelength of emitted light, n represents an average refractive index of a medium disposed between the reflective layer and the light emitting layer, and Δ≤λ/8n).

In the aforementioned LED, a distance between the reflective layer and the quantum well closest to the reflective layer allows a constructive interference between a light emitted by the light emitting layer and a light reflected by the reflective layer.

In the aforementioned LED, the distance between the reflective layer and the quantum well closest to the reflective layer is (2m+1)(λ/4n)-2α±Δ) (where, m represents a constant greater than zero, λ represents a wavelength of the emitted light, n represents an average refractive index of a medium disposed between the reflective layer and the light emitting layer, α represents a skin depth of light within the reflective layer, and Δ≤λ/8n).

In another embodiment, a light emitting device (LED) comprises a light emitting structure having a first conductivity-type semiconductor layer, a light emitting layer comprising a multiple quantum well structure, a second conductivity-type semiconductor layer; and a reflective layer on the light emitting structure. A distance between the reflective layer and the quantum well closest to the reflective layer allows a constructive interference between a light emitted by the light emitting layer and a light reflected by the reflective layer.

In the aforementioned LED, the distance between the reflective layer and the quantum well closest to the reflective layer is (2m+1)(λ/4n)-2α±Δ) (where, m represents a constant greater than zero, λ represents a wavelength of the emitted light, n represents an average refractive index of a medium disposed between the reflective layer and the light emitting layer, α represents a skin depth of light within the reflective layer, and Δ≤λ/8n).

In accordance with another embodiment, a light emitting device (LED) package comprises a light emitting structure comprising a first conductive type semiconductor layer, a light emitting layer comprising multiple quantum wells formed by a plurality of well layers and a plurality of barrier layers, and a second conductive type semiconductor layer; and a reflective layer adjacent to the light emitting structure, wherein a total thickness of a barrier layer and a well layer, which are adjacent to each other, is about λ/2n±Δ (where, λ represents a wavelength of emitted light, n represents an average refractive index of a medium disposed between the reflective layer and the light emitting layer, and Δ≤λ/8n).

In the aforementioned package, a thickness between the reflective layer and a well layer closest to the reflective layer is (2m+1)(λ/4n)-2α±Δ) (where, m represents a constant greater than zero, λ represents a wavelength of the emitted light, n represents an average refractive index of a medium disposed between the reflective layer and the light emitting layer, α represents a skin depth of light within the reflective layer, and Δ≤λ/8n).

In the descriptions of embodiments, it will be understood that when a layer (or film) is referred to as being 'on' another layer or substrate, it can be directly on another layer or substrate, or intervening layers may also be present. Further, it will be understood that when a layer is referred to as being 'under' another layer, it can be directly under another layer, and one or more intervening layers may also be present. In addition, it will also be understood that when a layer is referred to as being 'between' two layers, it can be the only layer between the two layers, or one or more intervening layers may also be present.

In the aforementioned embodiments, the first conductivity type and the second conductivity-type mentioned herein may be selected from the group consisting of an n-type or a p-type.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device (LED) comprising:
a light emitting structure comprising a first conductive type semiconductor layer, a light emitting layer, and a second conductive type semiconductor layer; and
a reflective layer on the light emitting structure;
wherein the light emitting layer includes multiple quantum wells, and
a distance between adjacent quantum wells is about λ/2n±Δ (where, λ represents a wavelength of emitted light, n represents an average refractive index of a medium disposed between the reflective layer and the light emitting layer, and Δ≤λ/8n).

2. The LED of claim 1, wherein a distance between the reflective layer and the quantum well closest to the reflective layer allows a constructive interference between a light emitted by the light emitting layer and a light reflected by the reflective layer.

3. The LED of claim 2, wherein the distance between the reflective layer and the quantum well closest to the reflective layer is (2m+1)(λ/4n)-2α±Δ) (where, m represents a constant greater than zero, λ represents a wavelength of the emitted light, n represents an average refractive index of a medium disposed between the reflective layer and the light emitting layer, α represents a skin depth of light within the reflective layer, and Δ≤λ/8n).

4. The LED of claim 1, wherein the reflective layer is provided adjacent to the second conductive type semiconductor layer.

5. The LED of claim 1, wherein the distance between the reflective layer and the quantum well closest to the reflective layer allows a constructive interference between a light emitted by the light emitting layer and a light reflected by the reflective layer.

6. The LED of claim 1, wherein the multiple quantum wells comprise a plurality of well layers and a plurality of barrier layers.

7. The LED of claim 6, wherein a total thickness of a barrier layer and a well layer, which are adjacent to each other, is about λ/2n±Δ (where, λ represents a wavelength of emitted light, n represents an average refractive index of a medium disposed between the reflective layer and the light emitting layer, and Δ≤λ/8n).

8. A lighting system comprising a light emitting module portion comprising the light emitting device package of claim 7.
